# EUROPEAN PATENT APPLICATION

(11) **EP 4 636 416 A1**
(43) Date of publication of application: **22.10.2025**
(21) Application number: 22968534.2
(22) Date of filing: 16.12.2022
(51) Int. Cl.: G01R 31/34

(54) **MISALIGNMENT DETECTION METHOD, MISALIGNMENT DETECTION DEVICE, AND MACHINE TOOL EQUIPPED WITH MISALIGNMENT DETECTION DEVICE**

(71) Applicant: DMG Mori Co., Ltd., Yamatokoriyama-shi, Nara 639-1160 (JP)
(72) Inventor: KATO, Yasutaka, Yamatokoriyama-shi, Nara 639-1160 (JP); FUJISHIMA, Makoto, Yamatokoriyama-shi, Nara 639-1160 (JP)
(74) Representative: Isarpatent
(86) International application number: PCT/JP2022/046355
(87) International publication number: WO 2024/127624

(57) **Abstract**

A misalignment detection device (75) includes a reference current storage unit (76) configured to store, as a reference current value, a drive current supplied to a drive motor (46a) when a rotary table is rotated at a predetermined rotation speed about a first axis in a reference state in which a mounting surface is in a horizontal state and a mount target is not mounted, and a misalignment detection unit (77). The misalignment detection unit (77) tilts the rotary table with the mount target attached to the mounting surface so that the mounting surface is at a predetermined angle relative to the horizontal surface, and acquires, as an actual current value, a drive current supplied to the drive motor (46a) when the rotary table in the tilted state is rotated at the predetermined rotation speed about the first axis. The misalignment detection unit (77) calculates the difference between the acquired actual current value and the reference current value stored in the reference current storage unit (76), and detects a misalignment state based on the obtained difference value.

## Description

### [TECHNICAL FIELD]

The present invention relates to a method and a device that detect the degree of misalignment of a placed object placed on a rotary table relative to the rotary table, and relates to a machine tool equipped with the device.

### [BACKGROUND ART]

For example, a method disclosed in Japanese Patent Application Laid-Open No. 2004-138423 is traditionally known as a method for detecting a misalignment as a deviation between an inertia axis including a center of gravity of a rotating body material and a rotation axis. The method not only detects the misalignment, but also detects the imbalance, which refers to the distribution of the inertial mass at each rotational angle. More specifically, the rotating body material is placed on a rotary table, which is supported by a spindle, so that its rotation axis aligns with the rotation axis of the spindle, and then the spindle is rotated by a motor and the amount of vibration in a direction perpendicular to the axis at each rotational angle of the spindle is detected, whereby the imbalance of the rotating body material is measured.

However, the above traditional method for detecting imbalance is designed to detect the imbalance of a rotating body material such as a cast product, which does not have its own balance, therefore its detection accuracy is low. When a machined product (placed object), that has been machined with a certain degree of precision and thus has a certain level of balance, is placed on the rotary table, the traditional imbalance detection method is incapable of accurately detecting the degree of misalignment including the mounting accuracy of the placed object relative to the rotary table, that is to say, the degree of positional deviation of the center of gravity (inertia axis) of the placed object relative to the rotating center axis of the rotary table.

Therefore, traditionally, in the field of machine tools equipped with rotary tables, misalignment has been detected as follows. First, after placing and fixing a workpiece (placed object) on the rotary table, the motor for the rotary table is driven to rotate the rotary table at a constant rotation speed, and during this time, the current value (equivalent to a torque value) that is supplied to the motor under feedback control is detected. Then, by comparing the detected current value (actual current value) with a reference current value serving as a standard, the state of misalignment between the axis of the mounted workpiece and the axis of the rotary table is detected.

The reference current value is, for example, a current value (equivalent to a torque value) supplied to the motor when the rotary table is rotated at a predetermined constant rotation speed by the motor, in the state with no object attached to the rotary table that is defined as a reference state. This current value varies in accordance with the rotational phase of the rotary table.

Then, when the target workpiece is attached on the rotary table and rotated, the difference value between the actual current value supplied to the motor and the reference current value is calculated, and the misalignment state is estimated based on the calculated difference value. That is, when there is no misalignment between the axis of the workpiece and the axis of the rotary table, the difference value is approximately 0, and when the workpiece is misaligned, the difference value increases according to the degree of misalignment. Therefore, the difference value between the actual current value and the reference current value can be calculated, and the misalignment state can be estimated from the difference value.

In this way, by detecting the misalignment state of the workpiece relative to the rotary table, if the misalignment is determined to exceed an allowable range, the acceleration and deceleration can be slowed down by reducing the time constant when rotating the rotary table, and the rotation speed of the rotary table can be limited.

### [PRIOR ART DOCUMENTS]

### [PATENT DOCUMENTS]

[Patent Document 1] Japanese Unexamined Patent Publication No. 2004-138423

### [SUMMARY OF THE INVENTION]

### [PROBLEM TO BE SOLVED]

However, the method of detecting the misalignment state of the target workpiece based on the current value supplied to the motor also has areas for improvement, as described below.

That is, in the case of a motor with a small output, the fluctuation component of the current value caused by the misalignment of the target workpiece becomes relatively large compared to the current value supplied to the motor, making the misalignment state easier to detect. However, in the case of a motor with a large output, it is difficult to detect the misalignment state because the fluctuation component of the current value caused by the misalignment of the target workpiece becomes relatively small compared to the current value supplied to the motor.

When the weight of the target workpiece attached to the rotary table is light compared to the weight of the rotary table, it is also difficult to detect the misalignment state because the fluctuation component of the current value caused by misalignment of the target workpiece becomes small.

The present invention has been developed in view of the above circumstances, and an object thereof is to provide a misalignment detection method and a misalignment detection device that are capable of detecting, more prominently than traditional techniques, a misalignment state including a mounting error of the placed object relative to the rotary table, even if the placed object attached to the rotary table is a machined workpiece, and to provide a machine tool equipped with the misalignment detection device.

### [SOLUTION TO PROBLEM]

In order to solve the above problem, the present invention particularly relates to a misalignment detection method and a misalignment detection device that are suitably implemented in a device (e.g., a machine tool) including: a rotary table that has a flat mounting surface, on which a placed object including a mount target is placed, and rotates about a first axis orthogonal to the mounting surface and about a second axis parallel to the mounting surface; and a drive motor that rotates the rotary table.

The misalignment detection method according to the present invention is a method for detecting, in the device, a degree of misalignment of the center of gravity of the placed object placed on the mounting surface of the rotary table relative to the first axis, and the method includes:
a reference current acquisition step of acquiring, as a reference current value, a drive current supplied to the drive motor when the rotary table is rotated at a predetermined rotation speed about the first axis in a reference state in which the mounting surface is in a horizontal state and the mount target is not mounted;
an actual current acquisition step of, after the mount target is mounted on the rotary table, rotating the rotary table about the second axis to tilt the rotary table so that the mounting surface thereof forms a predetermined angle with respect to the horizontal surface, and then acquiring, as an actual current value, a drive current supplied to the drive motor when the rotary table is rotated at the rotation speed about the first axis in the orientation-changed state; and
a misalignment detection step of calculating a difference value between the actual current value and the reference current value, and detecting the degree of misalignment based on the obtained difference value.

In this misalignment detection method, the reference current acquisition step is first performed, in which the rotary table is rotated at a predetermined rotation speed about the first axis in the reference state where the mounting surface is in a horizontal state and the mount target is not mounted, and the drive current value corresponding to the phase supplied to the drive motor at that time is acquired as the reference current value.

When the rotary table is not tilted, that is, when the mounting surface is in a horizontal state, rotating the rotary table about the first axis causes a load corresponding to the inertia of the rotary table without the mount target mounted thereon to act on the drive motor, particularly at the initial stage of rotation (during acceleration). On the other hand, when the rotation of the rotary table is in a constant speed state, unless an external force acts, there is not such a large load on the drive motor, and the drive current supplied to the drive motor is at a stable value. In the reference current acquisition step, a drive current value corresponding to the phase supplied to the drive motor when the rotary table in the reference state in which the mount target is not mounted thereon is rotated is acquired.

In the actual current acquisition step, after the mount target is mounted on the rotary table, the rotary table is rotated about the second axis to be tilted so that its mounting surface forms a predetermined angle with respect to the horizontal surface, and then, in the tilted state after the change in orientation, the rotary table is rotated at the rotation speed about the first axis and the drive current value corresponding to the phase supplied to the drive motor at that time is acquired as the actual current value.

When the rotary table that has the mount target mounted thereon and tilted by rotation to a predetermined angle about the second axis is rotated about the first axis, similarly to the above, a load corresponding to the inertia of the rotary table and the mount target acts on the drive motor at the initial stage of rotation (during acceleration). Then, when the rotation of the rotary table reaches a constant speed state, if the placed object is misaligned relative to the rotary table, that is, if the center of gravity of the placed object is not located on the rotating center axis of the rotary table but is offset therefrom, a force which is generated due to the rotation of the placed object acts as a load on the drive motor. This force includes a centrifugal force that corresponds to the mass of the placed object and depends on the amount of misalignment, and a component that is related to the gravitational force on the placed object and depends on the amount of misalignment and the tilt of the placed object. Therefore, the actual current value obtained in the actual current acquisition step includes a fluctuation component corresponding to the centrifugal force caused by the rotation of the placed object and the gravitational force of the placed object.

Where misalignment is present, the component related to the gravitational force on the placed object acts as a torque on the drive motor according to the amount of misalignment, which varies according to the rotational phase of the motor. For example, assuming that the phase at which the center of gravity of the placed object is located directly below the rotating center axis of the rotary table is defined as 0° and the center of gravity of the placed object swivels counterclockwise around the rotation axis of the rotary table as the rotary table rotates counterclockwise, at the rotational phase of 0°, although the downward gravitational force acts on the drive motor, no torque is acting on the drive motor. Then, when the rotational phase exceeds 0°, a gravitational component acting in the direction opposite to the rotational direction begins to act, and a reverse-direction torque (positive torque) corresponding to the gravitational component starts to act on the drive motor, reaching its maximum at the rotational phase of 90°. The positive torque acts in a direction that increases the load on the drive motor, and at the rotational phase of 90°, the torque acting as a load on the drive motor reaches its maximum.

When the rotational phase exceeds 90°, the reverse-direction torque (positive torque) gradually decreases, and when the phase reaches 180°, the torque becomes "0" and only the downward gravitational force acts on the drive motor. Then, when the rotation phase exceeds 180°, a gravitational component acting in the same direction (forward direction) as the rotational direction begins to act, and a forward-direction torque (negative torque) corresponding to the gravitational component starts to act on the drive motor, reaching its maximum at the rotational phase of 270°. The negative torque (forward-direction torque), acts in a direction that reduces the load on the drive motor. Accordingly, the torque acting as a load on the drive motor is minimized when the rotational phase is at 270°. Then, when the rotational phase exceeds 270°, the forward-direction torque (negative torque) gradually decreases, and when the phase reaches 0°, the torque becomes 0 and only downward gravitational force acts on the drive motor. On the other hand, where no misalignment is present, the component related to the gravitational force on the placed object does not act as a torque, although its constant value acts on the drive motor.

Next, in a misalignment detection step, the difference between the actual current value and the reference current value is calculated, and the degree of misalignment is detected based on the obtained difference value. The difference value indicates a larger value as the amount of misalignment is larger. Therefore, the magnitude of the difference value allows estimation (detection) of the magnitude of misalignment, that is, the degree of misalignment. Further, a difference value corresponding to the phase of the drive motor between the actual current value and the reference current value may be calculated, and the degree of misalignment can be estimated based on the difference between the maximum and minimum of the obtained difference value. That is, when there is no misalignment between the axis of the placed object and the axis (rotating center axis) of the rotary table, there is no significant variation in the difference value. However, when there is misalignment between the axis (including the center of gravity) of the placed object and the axis of the rotary table, the difference value includes a variation component corresponding to the centrifugal force caused by the rotation of the placed object and the gravitational force on the placed object, as described above. The component related to the gravitational force on the placed object acts as a torque on the drive motor and varies according to the rotational phase of the motor. Accordingly, the difference value varies depending on the magnitude of the misalignment and also varies with the rotational phase of the drive motor. Therefore, a difference value corresponding to the phase of the drive motor between the actual current value and the reference current value may be calculated, and the magnitude (degree) of misalignment can be estimated based on the difference between the maximum and minimum of the obtained difference value.

In this way, the misalignment detection method estimates the misalignment state based on the difference value between the actual current value and the reference current value when the rotary table with the mount target mounted thereon is rotated while in a tilted state. Therefore, even if the placed object mounted on the rotary table is a machined object, the degree of misalignment of the placed object relative to the rotary table can be detected more prominently than in the traditional method.

As described above, when the rotary table with the placed object mounted thereon is rotated while in a tilted state, if the placed object is misaligned relative to the rotary table, the load on the drive motor will include the centrifugal force that is caused by the rotation of the placed object and corresponds to the amount of misalignment, and a component that is related to the gravitational force on the placed object and depends on amount of the misalignment amount and the tilt of the placed object. Therefore, the actual current value obtained in the actual current acquisition step will include a fluctuation component corresponding to the centrifugal force caused by the rotation of the placed object and the gravitational force on the placed object.

On the other hand, when, as in the traditional method, the rotary table with the placed object mounted thereon is rotated without being tilted, if the object is misaligned relative to the rotary table, only the centrifugal force caused by the rotation of the placed object acts as a load on the drive motor. Therefore, the current value supplied to the drive motor in this state includes a fluctuation component corresponding only to the centrifugal force caused by the rotation of the placed object.

In the traditional method, the difference value between the actual current value and the reference current value reflects a fluctuation component corresponding only to the centrifugal force corresponding to the misalignment. However, in the misalignment detection method according to the present invention, the difference value between the actual current value and the reference current value includes a fluctuation component corresponding to the centrifugal force corresponding to the misalignment, as well as a fluctuation component corresponding to the gravitational force on the placed object. Therefore, the degree of misalignment of the placed object relative to the rotary table can be detected more prominently than in the traditional method.

Thus, according to the misalignment detection method of the present invention, compared to traditional methods, even when the placed object is a machined product that has been machined with a certain degree of precision and thus has a certain level of balance, the degree of misalignment of the placed object relative to the rotary table can be detected with sufficient accuracy. The misalignment state of the placed object relative to the rotary table can be detected more prominently, regardless of the output level of the drive motor, and can also be detected more prominently regardless of the weight of the placed object.

Note that, for example, in the case where a workpiece is directly mounted on the rotary table, the workpiece corresponds to the placed object, and the workpiece also corresponds to the mount target. In the case where a workpiece is attached to a mounting jig installed on the rotary table, the mounting jig and the workpiece correspond to the placed object, and the workpiece corresponds to the mount target. In addition, in the case where a mounting jig with a workpiece attached thereto is mounted on the rotary table, the mounting jig and the workpiece correspond to the placed object, and also correspond to the mount target.

Further, the misalignment detection device according to the present invention is a device capable of appropriately implementing the misalignment detection method described above, that is, for example, in the machine tool, detects the degree of misalignment of the center of gravity of the placed object placed on the mounting surface of the rotary table relative to the first axis, the device includes:
a reference current storage unit configured to store, as a reference current value, a drive current supplied to the drive motor when the rotary table is rotated at a predetermined rotation speed about the first axis in a reference state in which the mounting surface is in a horizontal state and the mount target is not mounted; and
a misalignment detection unit configured to acquire, as an actual current value, a drive current supplied to the drive motor when the rotary table with the mount target mounted thereon is rotated at the rotation speed about the first axis in an orientation-changed state in which the rotary table has been rotated about the second axis so that the mounting surface thereof forms a predetermined angle with respect to a horizontal surface, to calculate a difference value between the acquired actual current value and a reference current value stored in the reference current storage unit, and to detect the degree of misalignment based on the obtained difference value.

According to the misalignment detection device, the reference current value acquired in the same manner as the reference current acquisition step described above is stored in the reference current storage unit in advance.

Then, after the mount target is mounted on the rotary table, in the same manner as in the actual current acquisition step and the misalignment detection step, the rotary table is rotated about the second axis to be tilted so that the mounting surface thereof forms a predetermined angle with respect to a horizontal surface, and in this tilted state (orientation-changed state), a drive current supplied to the drive motor when the rotary table is rotated at the rotation speed about the first axis is acquired as an actual current value by the misalignment detection unit, a difference value between the acquired actual current value and the reference current value stored in the reference current storage unit is calculated and the degree of misalignment is detected based on the calculated difference value.

According to the misalignment detection device, the difference value between the actual current value and the reference current value includes a fluctuation component corresponding to the centrifugal force corresponding to the misalignment, as well as a fluctuation component corresponding to the gravitational force on the placed object. Therefore, the misalignment state of the placed object relative to the rotary table can be detected more prominently than in the traditional method. Thus, according to the misalignment detection device, compared to the traditional methods, even when the placed object is a machined product that has been machined with a certain degree of precision and thus has a certain level of balance, the degree of misalignment of the placed object relative to the rotary table can be detected with sufficient accuracy. The misalignment state of the placed object relative to the rotary table can be detected more prominently, regardless of the output level of the drive motor, and can also be detected more prominently regardless of the weight of the placed object.

In the misalignment detection method and the misalignment detection device described above, it is preferable that the rotary table be tilted about the second axis such that the mounting surface thereof forms an angle in the range of 15° to 90° with respect to the horizontal surface, more preferably in the range of 30° to 90°, still more preferably in the range of 45° to 90°, and most preferably in the range of 60° to 90°. It should be noted that, in the present invention, an orientation in which the rotary table is rotated such that the mounting surface thereof is at an angle of 90° relative to the horizontal surface is also included in the tilted orientation of the rotary table.

The present invention also relates to a machine tool equipped with the misalignment detection device described above. According to the machine tool, when mounting a mount target and performing a predetermined machining thereon, if the misalignment of the placed object relative to the table exceeds a predetermined standard, the acceleration and deceleration can be slowed down by reducing the time constant when rotating the table, and the rotation speed of the table can be limited.

### [ADVANTAGEOUS EFFECT OF THE INVENTION]

As described above, according to the present invention, compared to the traditional methods, even when the placed object is a machined product that has been machined with a certain degree of precision and thus has a certain level of balance, the degree of misalignment of the placed object relative to the rotary table can be detected with sufficient accuracy. The misalignment state of the placed object on the rotary table can be detected more prominently, regardless of the output level of the drive motor, and can also be detected more prominently regardless of the weight of the placed object.

### [BRIEF DESCRIPTION OF THE DRAWINGS]

[FIG. 1] FIG. 1 is a perspective view illustrating a machine tool according to an embodiment of the present invention.
[FIG. 2] FIG. 2 is a block diagram illustrating a schematic configuration of a control device according to the present embodiment.

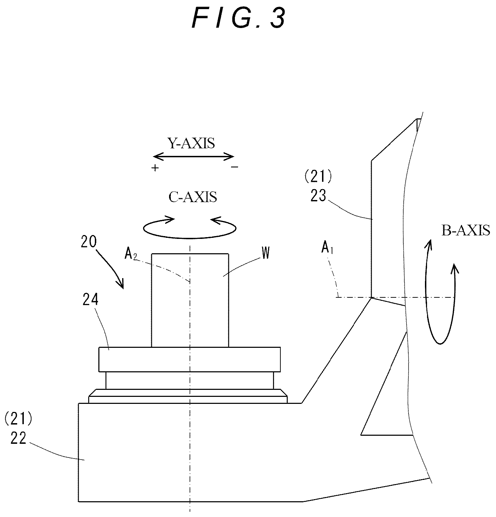

[FIG. 3] FIG. 3 is a side view illustrating a rotary table portion of the machine tool according to the present embodiment.

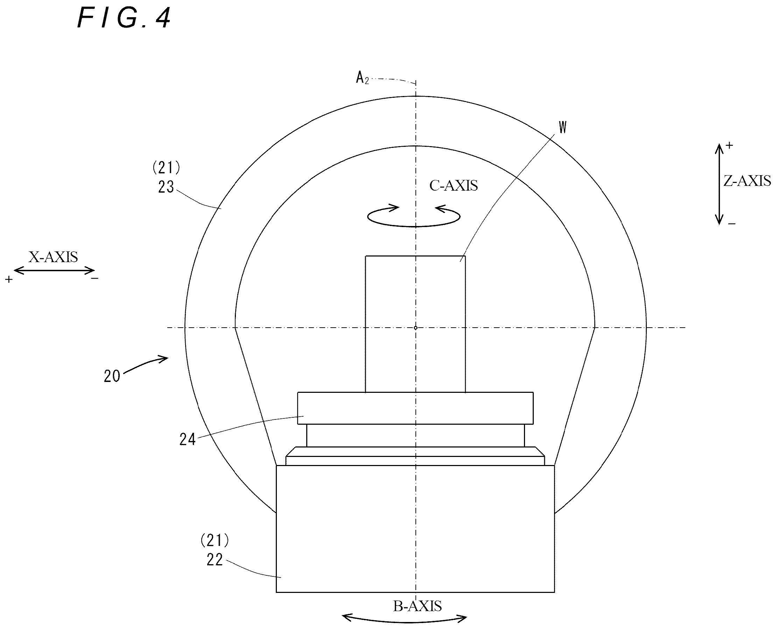

[FIG. 4] FIG. 4 is a front view illustrating the rotary table portion of the machine tool according to the present embodiment.
[FIG. 5] FIG. 5 is an explanatory diagram illustrating a misalignment detection method according to the present embodiment.
[FIG. 6] FIG. 6 is an explanatory diagram illustrating the misalignment detection method according to the present embodiment.
[FIG. 7] FIG. 7 is an explanatory diagram illustrating the misalignment detection method according to the present embodiment.
[FIG. 8] FIG. 8 is an explanatory diagram illustrating the misalignment detection method according to the present embodiment.
[FIG. 9] FIG. 9 is an explanatory diagram illustrating the misalignment detection method according to the present embodiment.
[FIG. 10] FIG. 10 is an explanatory diagram illustrating the misalignment detection method according to the present embodiment.
[FIG. 11] FIG. 11 is an explanatory diagram illustrating the misalignment detection method according to the present embodiment.
[FIG. 12] FIG. 12 is an explanatory diagram illustrating the misalignment detection method according to the present embodiment.
[FIG. 13] FIG. 13 is an explanatory diagram illustrating the misalignment detection method according to the present embodiment.
[FIG. 14] FIG. 14 is an explanatory diagram illustrating the misalignment detection method according to the present embodiment.
[FIG. 15] FIG. 15 is an explanatory diagram illustrating the misalignment detection method according to the present embodiment.
[FIG. 16] FIG. 16 is an explanatory diagram illustrating the misalignment detection method according to the present embodiment.
[FIG. 17] FIG. 17 is an explanatory diagram illustrating the misalignment detection method according to the present embodiment.
[FIG. 18] FIG. 18 is an explanatory diagram illustrating a variation of the present embodiment.

### [DETAILED DESCRIPTION]

Particular embodiments of the present invention will be described below with reference to the drawings.

### [Schematic Configuration Of Machine Tools]

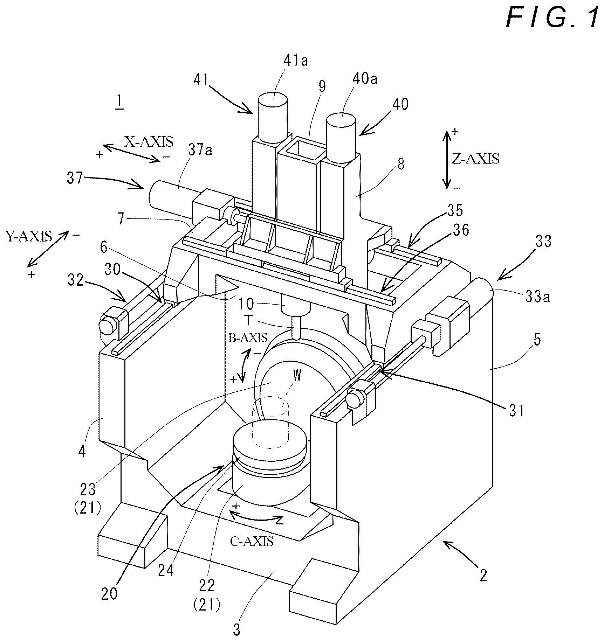

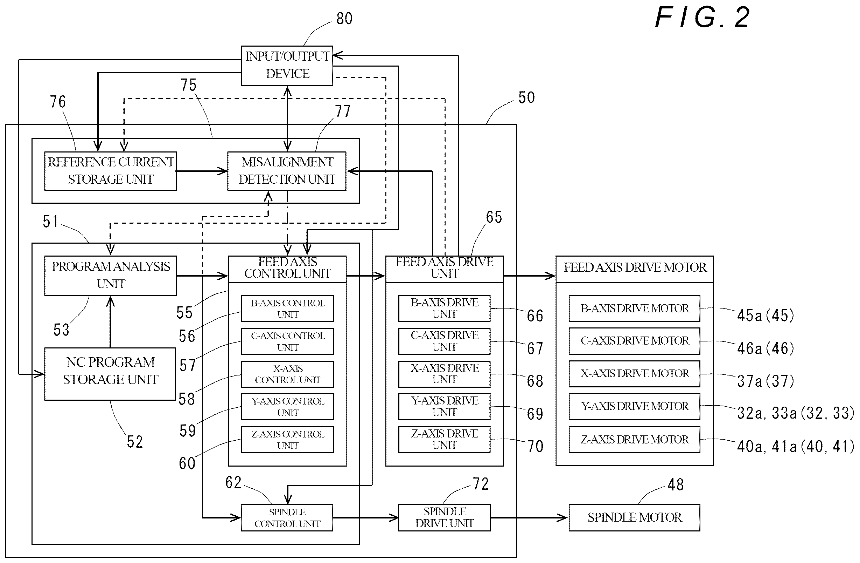

First, the schematic configuration of a machine tool according to one specific example of the present invention will be described below. As illustrated in FIG. 1 and FIG. 2, the machine tool 1 of the present example includes a bed 2, a first saddle 7 and a swing table mechanism 20 provided on the bed 2, a second saddle 8 provided on the first saddle 7, a spindle head 9 provided on the second saddle 8, and a control device 50.

The bed 2 includes a base 3 formed in a rectangular shape in a plan view, two side walls 4 and 5 that are respectively provided on the left and right sides (illustrated in the figure) of the base 3 so as to face each other, and a rear wall 6 provided between the side walls 4 and 5 on the rear side of the base 3 so as to be connected thereto.

The first saddle 7 is a frame body having a rectangular shape when viewed in plan, and is provided across the side walls 4 and 5 of the bed 2 so as to bridge them. The first saddle 7 is movable in the Y-axis direction, which is a horizontal front-rear direction feed axis, by Y-axis guide mechanisms 30 and 31 respectively provided on the top surfaces of the side walls 4 and 5. It is driven to move in the Y-axis direction by Y-axis drive mechanisms 32 and 33, which are provided on the top surfaces of the side walls 4 and 5 as well. The Y-axis drive mechanisms 32 and 33 are provided with Y-drive motors 32a and 33a, respectively.

The second saddle 8 is provided so as to pass through the frame of the first saddle 7, and is movable in the X-axis direction, which is a horizontal feed axis orthogonal to the Y-axis, by X-axis guide mechanisms 35 and 36 provided on both sides along the X-axis of the first saddle 7. The second saddle 8 is driven to move in the X-axis direction by an X-axis drive mechanism 37, which is also provided on the first saddle 7. The X-axis drive mechanism 37 includes an X-axis drive motor 37a.

The spindle head 9 is supported by the second saddle 8 via a Z-axis guide mechanism (not shown) provided on the second saddle 8, and is movable in the Z-axis direction, which is a feed axis orthogonal to the X-axis and the Y-axis. The spindle head 9 is driven to move in the Z-axis direction by Z-axis drive mechanisms 40 and 41 provided on both sides. The Z-axis drive mechanisms 40 and 41 are provided with Z-axis drive motors 40a and 41a, respectively. In addition, the spindle head 9 is provided with a spindle 10 so as to extend downward from the lower end thereof, and a tool T is attached to the lower end of the spindle 10. The spindle 10 is rotatably supported by the spindle head 9 and is rotated about its axis by a spindle motor 48.

The swing table mechanism 20 includes a table base 21 having an L-shaped configuration viewed from the left side, and a rotary table 24 provided on a horizontal portion 22 of the table base 21. The table base 21 is supported such that its vertical portion 23 is rotatable (swivel) about a rotation axis A₁, which is parallel to the Y-axis and positioned at the rear wall 6 of the bed 2. The table base 21 is rotatable in the B-axis direction, which is a rotation feed axis, and is driven to swivel in the B-axis direction by a B-axis drive mechanism 45 having a B-axis drive motor 45a. The rotation axis A₁ corresponds to a second axis.

The rotary table 24 is disposed on the horizontal portion 22 of the table base 21. The rotary table 24 is held on the horizontal portion 22 so as to be rotatable in a C-axis direction, which is a rotation feed axis, about a rotation axis A₂ that is parallel to the Z-axis and orthogonal to the top surface of the rotary table. The rotary table 24 is rotationally driven in the C-axis direction by a C-axis drive mechanism 47 having a C-axis drive motor 47a. The rotation axis A₂ corresponds to a first axis.

The X-axis drive motor 37a, the Y-axis drive motor 32a, 33a, and the Z-axis drive motor 40a, 41a, the B-axis drive motor 45a, and the C-axis drive motor 47a, which are feed axis drive motors, and the spindle motor 48 that drives the spindle 10 are controlled by the control device 50.

The control device 50 includes a numerical control device 51, a feed axis drive unit 65, a spindle drive unit 72, and a misalignment detection device 75, and an input/output device 80 is connected to the numerical control device 51 and the misalignment detection device 75.

The numerical control device 51 includes an NC program storage unit 52, a program analysis unit 53, a feed axis control unit 55, and a spindle control unit 62, and the misalignment detection device 75 includes a reference current storage unit 76 and a misalignment detection unit 77. The numerical control device (Numerical Controller) 51 and the misalignment detection device 75 are composed of a computer including a CPU, RAM, ROM, and the like, and the program analysis unit 53, the feed axis control unit 55, the spindle control unit 62, and the misalignment detection unit 77 implement the functions by the computer program and execute the processes described below. The NC program storage unit 52 and the reference current storage unit 76 are each composed of an appropriate storage medium such as RAM.

The NC program storage unit 52 is a functional unit that stores NC programs for NC control, such as machining programs, and stores NC programs input from, for example, the input/output device 80.

The program analysis unit 53 sequentially reads block by block, the NC program to be executed from among the NC programs stored in the NC program storage unit 52, and processes the NC codes contained in each block. When processing NC codes related to feed control of each feed axis, it transmits the corresponding commands to the feed axis control unit 55. When processing NC codes related to rotation control of the spindle 10, it transmits the corresponding commands to the spindle control unit 62.

The feed axis control unit 55 includes a B-axis control unit 56, a C-axis control unit 57, an X-axis control unit 58, a Y-axis control unit 59, and a Z-axis control unit 60, and transmits control signals to the feed axis drive unit 65 in accordance with commands related to NC codes sent from the program analysis unit 53. The feed axis drive unit 65 is an amplifier that supplies a drive current to the corresponding feed axis drive motor in accordance with the received control signal. The feed axis drive unit 65 is composed of a B-axis drive unit 66, a C-axis drive unit 67, an X-axis drive unit 68, a Y-axis drive unit 69, and a Z-axis drive unit 70.

More specifically, the B-axis control unit 56 receives a command related to the B-axis from the program analysis unit 53, transmits a corresponding control signal to the B-axis drive unit 66, and the B-axis drive unit 66 supplies a drive current to the B-axis drive motor 45a in accordance with the received control signal to rotate the B-axis drive motor 45a. The C-axis control unit 57 receives a command related to the C-axis from the program analysis unit 53, transmits a corresponding control signal to the C-axis drive unit 67, and the C-axis drive unit 67 supplies a drive current to the C-axis drive motor 46a in accordance with the received control signal to rotate the B-axis drive motor 45a.

The X-axis control unit 58 receives a command related to the X-axis from the program analysis unit 53, transmits a corresponding control signal to the X-axis drive unit 68, and the X-axis drive unit 68 supplies a drive current to the X-axis drive motor 37a in accordance with the received control signal to rotate the X-axis drive motor 37a. The Y-axis control unit 59 receives a command related to the Y-axis from the program analysis unit 53, transmits a corresponding control signal to the Y-axis drive unit 69, and the Y-axis drive unit 69 supplies a drive current to the Y-axis drive motor 32a and 33a in accordance with the received control signal to rotate the Y-axis drive motor 32a and 33a. The Z-axis control unit 60 receives a command related to the Z-axis from the program analysis unit 53, transmits a corresponding control signal to the Z-axis drive unit 70, and the Z-axis drive unit 70 supplies a drive current to the Z-axis drive motor 40a and 41a in accordance with the received control signal to rotate the Z-axis drive motor 40a and 41a.

Further, when the spindle control unit 62 receives a command related to the rotation control of the spindle 10 from the program analysis unit 53, it transmits a corresponding control signal to the spindle drive unit 72. The spindle drive unit 72 is an amplifier that supplies a drive current to the spindle motor 48 in accordance with the control signal received from the spindle control unit 62, thereby rotating the spindle motor 48.

In the machine tool 1 of this example having the above configuration, under the control by the numerical control device 51, a tool mounted on the spindle 10 and a workpiece W placed and fixed on the rotary table 24 move relative to each other in the X-axis, Y-axis, and Z-axis directions, which are orthogonal feed axes, by the X-axis drive mechanism 37, the Y-axis drive mechanisms 32 and 33, and the Z-axis drive mechanisms 40 and 41. Further, the rotary table 24 is driven by the B-axis drive mechanism 45 to swivel in the B-axis direction, which is a rotation feed axis, and is also driven by the C-axis drive mechanism 47 to rotate in the C-axis direction, which is also a rotation feed axis.

Then, by relatively moving the tool T mounted on the spindle 10 and the workpiece W placed and fixed on the table 24 in the X-axis, Y-axis, Z-axis, B-axis, and C-axis directions by the X-axis drive mechanism 37, the Y-axis drive mechanisms 32 and 33, the Z-axis drive mechanisms 40 and 41, the B-axis drive mechanism 45, and the C-axis drive mechanism 47, the workpiece W on the table 24 is machined by the tool T.

Further, as shown by the dashed arrow in FIG. 2, the input device 80 allows NC codes to be input into the program analysis unit 53 via MDI (Manual Data Input). By inputting NC codes into the program analysis unit 53 through the MDI**,** under the control by the program analysis unit 53, the feed axis control unit 55 and the spindle control unit 62, the feed axis drive unit 65 and the spindle drive unit 72 drive the respective feed axis drive motors and the spindle motor 48.

In addition, the feed axis control unit 55 and the spindle control unit 62 are configured to receive manual operation signals from the input device 80. Under the control by the feed axis control unit 55 and the spindle control unit 62, in response to the manual operation signals, each feed axis drive motor and the spindle motor 48 are driven via the feed axis drive unit 65 and the spindle drive unit 72.

The misalignment detection device 75 is composed of a reference current storage unit 76 and a misalignment detection unit 77.

The reference current storage unit 76 is a functional unit that stores a reference current value, which is the current value supplied from the C-axis drive unit 67 to the C-axis drive motor 46a. The reference current value is acquired as the drive current value corresponding to the rotational phase, which is supplied to the C-axis drive motor 46a when the rotary table 24, in a reference state where its top surface (mounting surface) is in a horizontal state and no object (such as the workpiece W shown in FIG. 1) is attached thereto, is rotated at a predetermined speed about the rotation axis A₂ under the control by the C-axis control unit 57. In this example, the workpiece W also corresponds to the placed object.

The rotational operation (reference current value acquisition operation) of the rotary table 24 in its reference state can be realized by manual operation, that is, by a manual operation signal input by the operator through the input/output device 80. For example, by inputting operation signals for the B-axis and C-axis from the input/output device 80 into the feed axis control unit 55, the B-axis drive motor 45a and C-axis drive motor 46a are driven via the B-axis drive unit 66 and C-axis drive unit 67 of the feed axis drive unit 65 under the control by the B-axis control unit 56 and C-axis control unit 57, to swivel the table 24 in the B-axis direction so that its top surface becomes level, and then to rotate it at a predetermined rotation speed about the rotation axis A₂.

At this time, as a reference current value, the current value supplied from the C-axis drive unit 67 to the C-axis drive motor 46a is transmitted to the input/output device 80 and displayed on the input/output device 80. The operator inputs the reference current value, which is displayed on the input/output device 80, into the reference current value storage unit 76 via the input/output device 80. In addition, when inputting the manual operation signal via the input/output device 80, an aspect of inputting the manual operation signal (B-axis and C-axis operation signals) can be adopted by specifying a reference operation mode. In this case, the reference current value can be directly transmitted from the feed axis drive unit 65 to the reference current storage unit 76 and stored without going through the input/output device 80 (see the dashed arrow indicating the transmission path in FIG. 2).

The misalignment detection unit 77, after a mount target (in this example, the workpiece W) is attached to the rotary table 24, causes the rotary table 24 to rotate (swivel) about the rotation axis A₁ so that its top surface is tilted to a predetermined angle relative to the horizontal surface. In this tilted state with its orientation changed, when the rotary table 24 is rotated about the rotation axis A₂ at the predetermined rotation speed, the current value corresponding to the rotational phase that supplied to the C-axis drive motor 46a is acquired from the C-axis drive control unit 67 as the actual current value. Then, the difference value between the acquired actual current value and the reference current value stored in the reference current storage unit 76 is calculated, and the misalignment degree is detected based on the obtained difference value.

Next, in the machine tool 1 having the above configuration, the misalignment detection processing by the misalignment detection device 75 will be described.

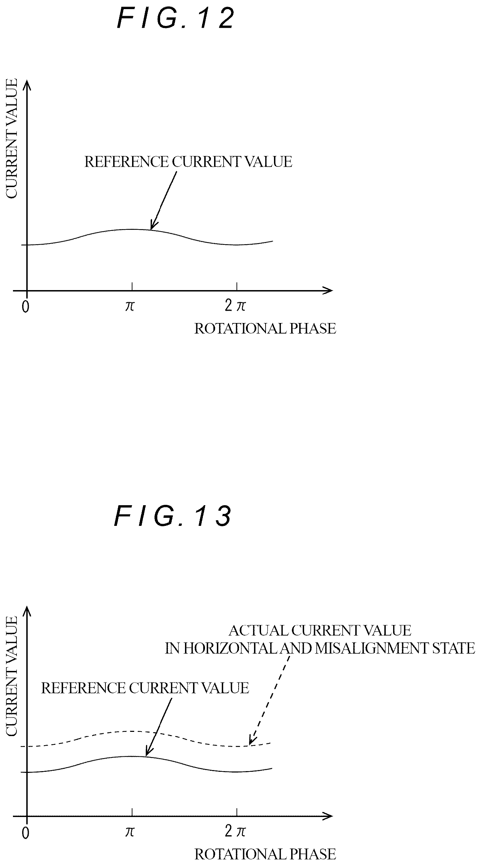

First, as described above, under the control by the B-axis control unit 56 and the C-axis control unit 57, the B-axis drive motor 54a and the C-axis drive motor 46a are driven via the B-axis drive unit 66 and the C-axis drive unit 67, to swivel the table 24 in the B-axis direction so that its top surface becomes level, and then to rotate it in the C-axis direction at the predetermined rotation speed. Then, the current value supplied from the C-axis drive unit 67 to the C-axis drive motor 46a at this time is acquired as the reference current value, and the acquired reference current value is stored in the reference current value memory unit 76. An example of the waveform of the current value corresponding to the rotational phase of the rotary table 24 obtained at this time is shown in FIG. 12. The 0° rotation phase is the reference position, which is appropriately defined, and is, for example, defined as a rotational phase described later. Note that the waveform shown in FIG. 12 is only a conceptual one for explaining the present embodiment, and does not indicate the actual value of the waveform.

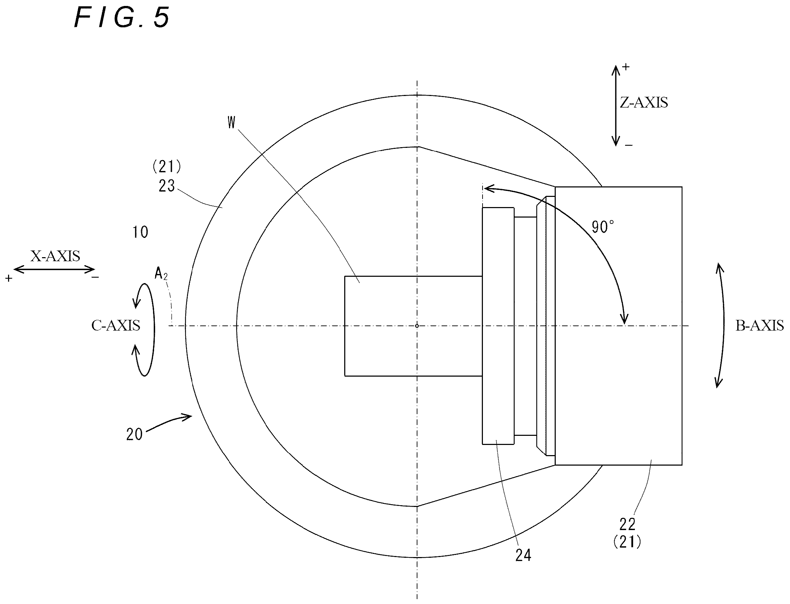

Then, as described above, after attaching the workpiece W to the rotary table 24, for example, under the control by the B-axis control unit 56, the B-axis drive motor 54a is driven via the B-axis drive unit 66 to rotate (swivel) the rotary table 24 in the B-axis direction so that its top surface is tilted at a predetermined angle relative to the horizontal surface, such as orientation at 90° (in the present invention, the orientation at 90° is also considered as a tilted orientation) (see FIG. 5). After that, under the control by the C-axis control unit 57, the C-axis drive motor 46a is driven via the C-axis drive unit 67, to rotate the rotary table 24 in the C-axis direction at the predetermined rotation speed. Then, the misalignment detection unit 77 acquires the current value supplied from the C-axis drive unit 67 to the C-axis drive motor 46a at that time as the actual current value, calculates the difference value between the actual current value and the reference current value stored in the reference current storage unit 76, and detects the misalignment degree based on the obtained difference value. For example, if the difference value is greater than a theoretically or empirically determined threshold, it is determined that there is misalignment that needs to be addressed.

Next, the principle for detecting the misalignment degree is described below.

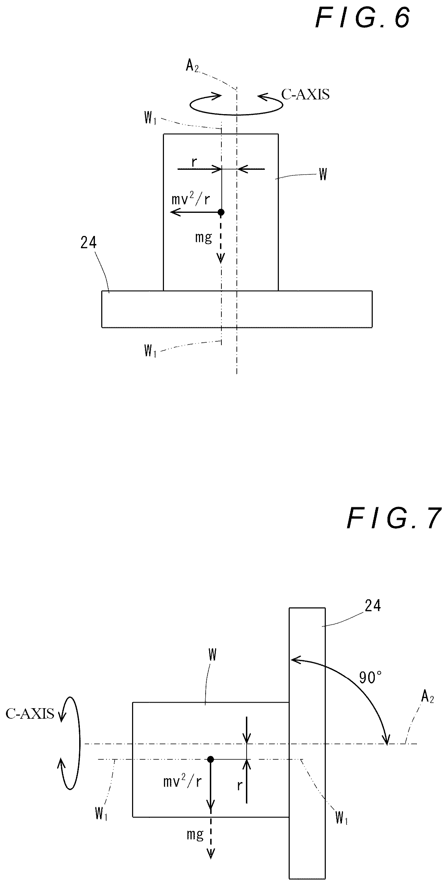

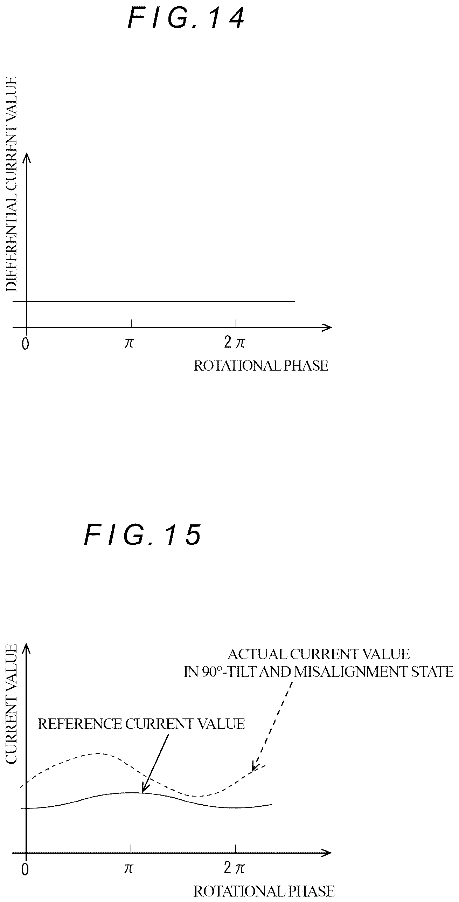

First, considering the state where the rotary table 24, with the workpiece W attached to it, has its upper surface in a horizontal orientation, if the workpiece W is attached with misalignment relative to the rotary table 24, then when the rotary table 24 is rotated by a predetermined rotation (one or more revolutions) in the C-axis direction at the predetermined rotation speed, a centrifugal force (=mv²/r), corresponding to the mass of the workpiece W, acts on the C-axis drive motor 46a, as shown in FIG. 6. Here, m is the mass of the workpiece W, v is the rotation speed of the workpiece W, and r is the amount of radial misalignment of the central axis W1, which includes the center of gravity of the workpiece W, relative to the rotation axis A₂ of the rotary table 24. Therefore, in this state, the waveform of the actual current values supplied from the C-axis drive unit 67 to the C-axis drive motor 46a, in accordance with the rotational phase of the rotary table 24, becomes a waveform shifted in the direction of increased current values, relative to the reference current values, by an amount corresponding to the centrifugal force (see FIG. 13). Then, the difference value between the actual current value and the reference current value in this state corresponds to the centrifugal force, and takes on a larger value as the misalignment amount increases, becoming approximately constant as shown in FIG. 14.

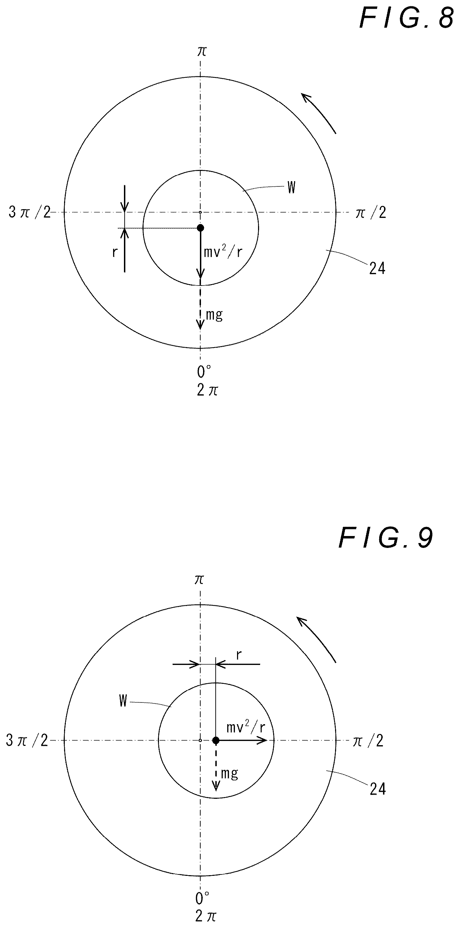

On the other hand, in the case where the workpiece W is attached with its central axis W1 misaligned relative to the rotation axis A₂ of the rotary table 24, when the rotary table 24 is tilted by 90° in the B-axis direction and then rotated by a predetermined amount in the C-axis direction at the predetermined rotation speed, as shown in FIG. 7, in addition to the centrifugal force (= mv²/r) corresponding to the mass of the workpiece W, the gravitational force (= mg) of the workpiece W also acts as torque on the C-axis drive motor 46a (see also FIG. 8 to FIG. 11). The torque is, as shown in FIG. 8 to FIG. 11, when the center of gravity of the workpiece W is positioned directly below the rotation axis A₂ of the rotary table 24, that rotational phase of the rotary table 24 is defined as 0°, when the rotary table 24 rotates counterclockwise (in the arrow-indicated direction), causing the workpiece W to rotate counterclockwise about the rotation axis A₂, at the 0° rotational phase, although the downward gravitational force acts on the C-axis drive motor 46a, no torque is generated (see FIG. 8). As the rotational phase exceeds 0°, a gravitational component opposite to the rotational direction begins to act, and a reverse-direction torque (positive torque) corresponding to that gravitational component begins to act on the C-axis drive motor 46a, the rotational phase reaches a maximum at 90° (see FIG. 9). The positive torque acts in a direction that increases the load on the C-axis drive motor 46a, and at the rotational phase of 90°, the torque acting as a load on the C-axis drive motor 46a reaches its maximum.

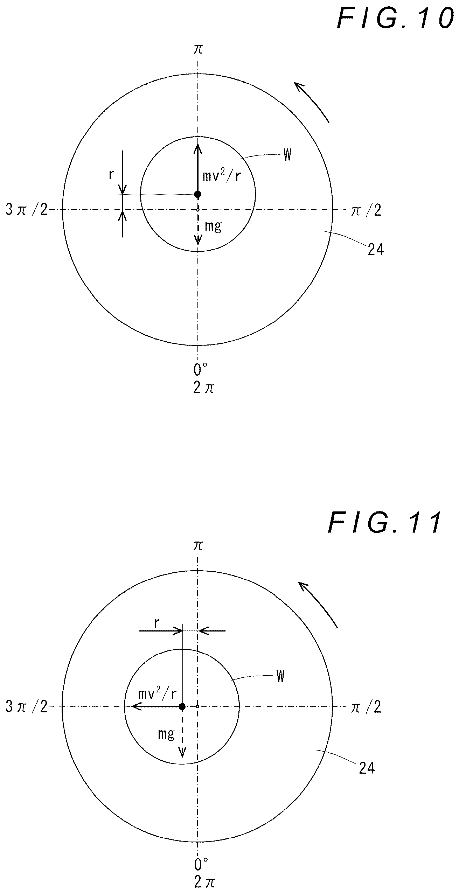

Then, when the rotational phase exceeds π/2 (=90°), the torque (positive torque) in the reverse direction gradually decreases, and when the rotational phase becomes π (=180°), the torque becomes "0", and only downward gravitational force acts on the C-axis drive motor 46a (see FIG. 10). Next, when the rotation phase exceeds π(=180°), the gravitational component acting in the same direction (forward direction) as the rotational direction begins to act, and the forward-direction torque (negative torque) corresponding to the gravitational component starts to act on the C-axis drive motor 46a, reaching its maximum at a rotational phase of 3π/2(=270°) (see FIG. 11). The negative torque (forward-direction torque), acts in a direction that reduces the load on the C-axis drive motor 46a. Accordingly, at a rotational phase of 3π/2(=270°), the torque acting as a load on the C-axis drive motor 46a becomes minimal. Then, when the rotational phase exceeds 3π/2(=270°), the torque (negative torque) in the forward direction gradually decreases, and when the phase reaches 0°, the torque becomes "0", and only downward gravitational force acts on the drive motor (see FIG. 8).

Therefore, the actual current value supplied from the C-axis drive unit 67 to the C-axis drive motor 46a, corresponding to the rotational phase of the rotary table 24, becomes the reference current value described above plus a current value caused by the centrifugal force (=mv2/r) corresponding to the mass of the workpiece W and the torque corresponding to the gravitational force (=mg) of the workpiece W. An example of such a waveform of the actual current value is shown in FIG. 15. In FIG. 15, the solid line represents the waveform of the reference current value, and the dashed line represent the waveform of the actual current value. Note that the waveform shown in FIG. 15, like the waveform shown in FIG. 12, is only a conceptual one for explaining the present embodiment, and does not indicate the actual value of the waveform.

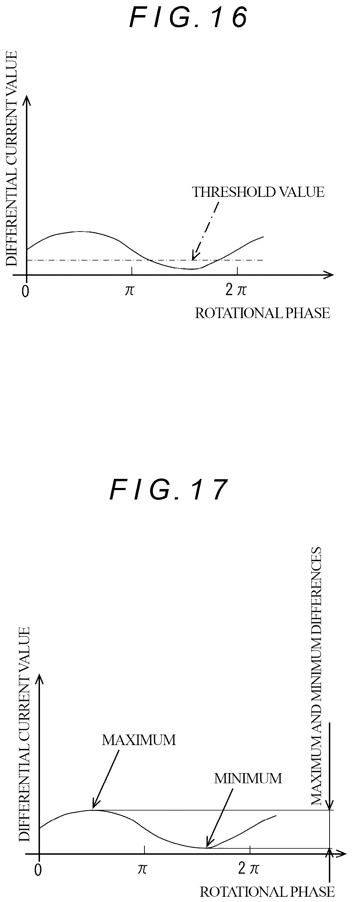

Then, in this state, when the rotary table 24 is tilted by 90°, if the workpiece W is attached on the rotary table 24 with a misalignment, the difference value between the actual current value and the reference current value increases, as described above, due to the centrifugal force and torque. This difference grows larger as the amount of misalignment increases, and the waveform of the difference value appears as shown, for example, in FIG. 16. Note that the waveform shown in FIG. 16 is a waveform showing the difference value between the actual current value and the reference current value shown in FIG. 15.

The misalignment detection unit 77 thus compares the obtained difference value to a predetermined threshold and determines that if the difference value is greater than the above threshold, there is misalignment that needs to be addressed (see FIG. 16).

As described in detail above, according to the misalignment detection device 75 of the present example, it is possible to detect the misalignment state of the workpiece W relative to the rotary table 24 more prominently than the traditional methods.

That is, as described above, according to the traditional method for detecting misalignment, the rotary table 24 with the workpiece W attached thereon is rotated in the C-axis direction at a predetermined rotation speed while its top surface is maintained in a horizontal orientation. Therefore, when the workpiece W is attached on the table 24 with misalignment, a centrifugal force corresponding to the mass of the workpiece W acts on the C-axis drive motor 46a. As a result, the actual current value supplied from the C-axis drive unit 67 to the C-axis drive motor 46a becomes a value in which a current corresponding to the centrifugal force is added as a fluctuation component to the reference current value.

On the other hand, according to the detection method of the present embodiment, the rotary table 24 with the workpiece W attached thereon is swiveled in the B-axis direction so that its top surface is tilted to a predetermined angle (90° in this example) relative to the horizontal surface. Thereafter, the table 24 is rotated in the C-axis direction at a predetermined rotation speed. Therefore, when the workpiece W is attached on the table 24 with misalignment, a centrifugal force corresponding to the mass of the workpiece W and a torque corresponding to the gravitational force of the workpiece W act on the C-axis drive motor 46a. As a result, the actual current value supplied from the C-axis drive unit 67 to the C-axis drive motor 46a is obtained by adding the current value corresponding to the centrifugal force and torque as fluctuation components to the reference current value.

Thus, according to the present embodiment, the difference value between the actual current value and the reference current value includes, as a fluctuation component, a current value corresponding to the torque due to the gravitational force of the workpiece W, which is not included in traditional aspect. Accordingly, compared to traditional methods, the misalignment degree of the workpiece W relative to the rotary table 24 can be detected more prominently.

Thus, according to the misalignment detection device 75 and the misalignment detection method of the present embodiment, compared to traditional methods, even for workpiece W that has been processed with a certain degree of precision and thus has a certain level of balance, the misalignment degree of the workpiece W relative to the rotary table 24 can be detected with sufficient accuracy. The degree of misalignment of the workpiece W relative to the rotary table 24 can be detected more prominently, regardless of the output level of the C-axis drive motor 46a that is a drive motor, and furthermore, can be detected more prominently regardless of the weight of the workpiece W. If the misalignment of the workpiece W relative to the rotary table 24 exceeds the predetermined standard, the acceleration and deceleration can be slowed down by reducing the time constant when the rotating table 24 is rotated, and the rotation speed of the rotating table 24 can be limited.

While one embodiment of the present invention has been described above, the specific aspects that the invention can take are not limited to the embodiment described.

For example, in the example described above, the difference value between the actual current value and the reference current value corresponding to the rotational phase of the C-axis drive motor 46a is compared with a predetermined threshold in the misalignment detection unit 77. If the difference value exceeds the threshold, it is determined that the misalignment needs to be addressed. However, this is not the only method, and it is also possible to calculate the difference between the maximum and minimum values of the difference value corresponding to the rotational phase of the C-axis drive motor 46a (see FIG. 17), and detect the misalignment degree of the workpiece W based on this maximum-minimum difference. That is, if the maximum and minimum differences are large, and the misalignment amount is larger than a predetermined threshold, it can be determined that there is misalignment that needs to be addressed.

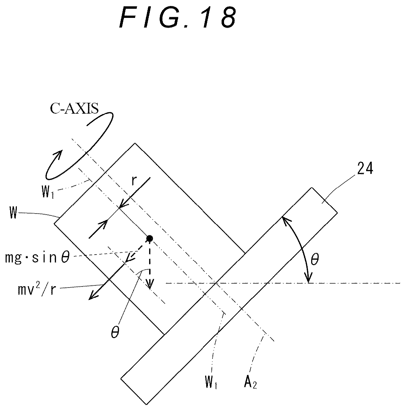

In the above example, the table 24 is rotated so that its top surface (mounting surface) is 90° relative to the horizontal surface, but it is not limited thereto, and the table 24 may be tilted at a predetermined angle θ relative to the horizontal surface. A state in which the table 24 is tilted at an angle θ is shown in FIG. 18. In this state, when the table 24 is rotated in the C-axis direction at a predetermined rotation speed, if the workpiece W is attached with a misalignment amount r relative to the table 24, the centrifugal force (=mv2/r) corresponding to the mass m of the workpiece W, and the torque (=r·mg·sinθ) corresponding to the gravitational force mg of the workpiece W act on the C-axis drive motor 46a. Due to the action of such torque (=r·mg·sinθ), the misalignment state of the workpiece W relative to the rotating table 24 can be detected more prominently compared to traditional methods.

Preferably, the tilt angle θ of the rotary table 24 is within a range of 15° to 90°, more preferably within a range of 30° to 90°, even more preferably within a range of 45° to 90°, and most preferably within a range of 60° to 90°. The larger the tilt angle θ of the rotary table 24, the more prominently the misalignment degree of the workpiece W relative to the rotary table 24 can be detected.

Further, in the above example, after acquiring the reference current value, the actual current value was obtained. However, this is not limited thereto, and it is also possible to reverse the order, such that the actual current value is obtained first, followed by the reference current value.

In the above example, the operation for acquiring the reference current value and the acquisition of the reference current, as well as the operation for acquiring the actual current value and the acquisition of the actual current are performed by manual operation through the input/output device 80, but are not limited thereto, and these can be performed by a predetermined NC program. In this case, the NC program is stored in the NC program storage unit 52 in advance and is preferably executed by the program analysis unit 51. In this aspect, the processing start signal in the misalignment detection unit 77 is transmitted from the program analysis unit 51 to the misalignment detection unit 77 (the transmission path from the program analysis unit 51 to the misalignment detection unit 77 is shown by a dashed line in FIG. 2), and the misalignment detection unit 77 executes the above misalignment detection process. Alternatively, as shown by the dotted line in FIG. 2, the operation to acquire the reference current value and the operation to acquire the actual current value may be executed based on the instructions (control signals) from the misalignment detection unit 77.

Also, in the above example, the workpiece W is illustrated as the placed object and the mount target attached to the rotary table 24, and this workpiece W was directly attached to the table 24. However, this is not limited thereto, the workpiece W may be attached to a mounting jig attached on the table 24. In this case, the mounting jig and the workpiece W correspond to the placed object, and the workpiece W corresponds to the mount target. In addition, a mounting jig with a workpiece W attached thereto may be mounted on the table 24, the mounting jig and the workpiece correspond to the placed object, and also correspond to the mount target.

Again, note that the above description of embodiments is in all respects illustrative and not restrictive. Variations and modifications are possible for those skilled in the art. The scope of the present disclosure is indicated by the claims, not by the embodiments described above. Further, the scope of the present invention includes modifications of the embodiments that fall within the scope of the patent claims and the equivalents.

### [LISTING OF REFERENCE CHARACTERS]

1: Machine Tool
20: Swing Table Mechanism
24: Rotary Table
32a, 33a: Y-axis Drive Motor
37a: X-axis Drive Motor
40a, 41a: Z-axis Drive Motor
50: Control Device
51: Numerical Control Device
52: NC Program Storage Unit
53: Program Analysis Unit
55: Feed Axis Control Unit
65: Feed Axis Drive Unit
75: Misalignment Detection Device
76: Reference Current Storage Unit
77: Misalignment Detection Unit

## Claims

1. A misalignment detection method that detects a degree of misalignment of a center of gravity of a placed object on a rotary table relative to a first axis in a device that includes: the rotary table having a flat mounting surface, on which the placed object including a mount target is placed, and configured to rotate about the first axis orthogonal to the mounting surface and rotate about a second axis parallel to the mounting surface; and a drive motor configured to rotate the rotary table, the method comprising:
a reference current acquisition step of acquiring, as a reference current value, a drive current supplied to the drive motor when the rotary table is rotated at a predetermined rotation speed about the first axis in a reference state in which the mounting surface is in a horizontal state and the mount target is not mounted;
an actual current acquisition step of, after the mount target is mounted on the rotary table, rotating the rotary table about the second axis so that the mounting surface thereof forms a predetermined angle with respect to a horizontal surface, and then acquiring, as an actual current value, a drive current supplied to the drive motor when the rotary table in the orientation-changed state is rotated at the rotation speed about the first axis; and
a misalignment detection step of calculating a difference value between the actual current value and the reference current value, and detecting the degree of misalignment based on the obtained difference value.

2. The misalignment detection method of claim 1, wherein the misalignment detection step detects the degree of misalignment based on a difference between a maximum value and a minimum value of the obtained difference value.

3. The misalignment detection method of claim 1 or 2, wherein in the actual current acquisition step, the rotary table is rotated about the second axis so that the mounting surface thereof is within the range of 15° to 90° relative to the horizontal surface.

4. A misalignment detection device that detects a degree of misalignment of a center of gravity of a placed object on a rotary table relative to a first axis in a device that includes: the rotary table having a flat mounting surface, on which the placed object including a mount target is placed, and configured to rotate about the first axis orthogonal to the mounting surface and rotate about a second axis parallel to the mounting surface; and a drive motor configured to rotate the rotary table, the misalignment detection device comprising:
a reference current storage unit configured to store, as a reference current value, a drive current supplied to the drive motor when the rotary table is rotated at a predetermined rotation speed about the first axis in a reference state in which the mounting surface is in a horizontal state and the mount target is not mounted; and
a misalignment detection unit configured to acquire, as an actual current value, a drive current supplied to the drive motor when the rotary table with the mount target mounted thereon is rotated at the rotation speed about the first axis in an orientation-changed state in which the rotary table has been rotated about the second axis so that the mounting surface thereof forms a predetermined angle with respect to a horizontal surface, to calculate a difference value between the acquired actual current value and the reference current value stored in the reference current storage unit, and to detect the degree of misalignment based on the obtained difference value.

5. The misalignment detection device of claim 4, wherein the misalignment detection unit detects the degree of misalignment based on a difference between a maximum value and a minimum value of the obtained difference value.

6. The misalignment detection device of claim 4 or 5, wherein the actual current value is the drive current when the rotary table is rotated about the second axis so that the mounting surface thereof is within the range of 15° to 90° relative to the horizontal surface.

7. A machine tool equipped with the misalignment detection device of claim 4 or 5.

8. A machine tool equipped with the misalignment detection device of claim 6.
